# EUROPEAN PATENT APPLICATION

(11) **EP 1 698 633 A1**
(43) Date of publication of application: **06.09.2006**
(21) Application number: 06004213.2
(22) Date of filing: 02.03.2006
(51) Int. Cl.: C07F 7/21, C08G 77/16, H01L 21/312

(54) **Composition, insulating film and process for producing the same**

(30) Priority: 02.03.2005 JP 2005057985
(71) Applicant: FUJI PHOTO FILM CO., LTD., Minami-Ashigara-shi, Kanagawa (JP)
(72) Inventor: Morita, Kensuke, Yoshida-cho, Haibara-gun, Shizuoka (JP)
(74) Representative: HOFFMANN EITLE

(57) **Abstract**

A composition comprising at least one of a compound represented by formula (I); a hydrolysate of the compound represented by formula (I); and a condensate of the compound represented by formula (I) and the hydrolysate of the compound represented by formula (I): 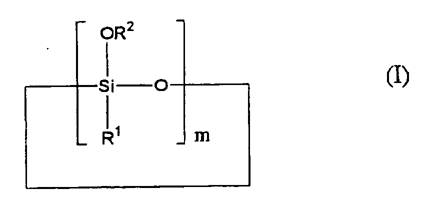 wherein m represents an integer of from 5 to 30; R¹ represents a hydrogen atom or a substituent; and R² represents a hydrogen atom or a group represented by formula (II), provided that at least one of R²s represents a group represented by formula (II): 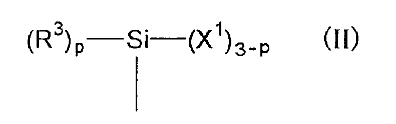 wherein R³ represents a hydrogen atom or a non-hydrolyzable group; X¹ represents a hydroxyl group or a hydrolyzable group; and p represents an integer of from 0 to 3.

## Description

### Background of the Invention

### 1. Field of the Invention

The present invention relates to a film forming composition, more specifically, to an insulating film forming composition capable of forming a film having an adequate and uniform thickness as an interlayer insulating film material in semiconductor elements or the like and excellent in dielectric constant characteristics and the like; a process for producing the insulating film; and the insulating film.

### 2. Description of the Related Art

A silica (SiO₂) film formed by vacuum processes such as chemical vapor deposition (CVD) has been used frequently as an interlayer insulating film in semiconductor elements. In recent years, an application type insulating film called "SOG (Spin on Glass) film" which is composed mainly of the hydrolysate of a tetraalkoxysilane has come to be used for the purpose of forming a more uniform interlayer insulating film. In addition, with an increase in the integration degree of semiconductor elements, an interlayer insulating film called "organic SOG" which is composed mainly of polyorganosiloxane and has a low dielectric constant has been developed.

Even a CVD-SiO₂ film exhibiting the lowest dielectric constant among films made of an inorganic material has a dielectric constant of about 4. A SiOF film which has recently been investigated as a low-dielectric-constant CVD film has a dielectric constant of from about 3.3 to 3.5. This film however has a problem that it has a high hygroscopic property and therefore its dielectric constant increases during use.

Under such situations, known is a method of making a film porous by adding a high-boiling-point solvent or thermally decomposable compound to organopolysiloxane as an insulating film material excellent in insulating property, heat resistance and durability, thereby decreasing the dielectric constant of the film. The porous film thus prepared still has problems such as reduced mechanical strength and occurrence of an increase in dielectric constant by moisture absorption even if the dielectric constant characteristics can be decreased by making the film porous. In addition, since pores are linked each other, copper used for wiring diffuses in the insulating film and becomes another problem.

Attempts to decrease a dielectric constant by using a siloxane compound having a cyclic structure are already known (refer to Japanese Patent Laid-Open Nos. 2000-281904, 2000-309753 and 2005-023075). Processes using a cyclic structure composed of 4 or 5 silicon atoms shown in these documents are not so effective for reducing the density of an insulating film and they cannot attain a sufficient reduction in the dielectric constant.

### Summary of the Invention

An object of the present invention is therefore to overcome the above-described problems by providing a composition, a process for producing an insulating film and an insulating film formed by using it, more specifically to provide a composition capable of forming a silicone film suited for use as an interlayer insulating film of a semiconductor element or the like, an insulating film excellent in dielectric constant characteristics and having an adequate and uniform thickness and film strength, and a process for producing the same.

It has been found that the above-described object of the present invention can be attained by the below-described means:
(1) A composition comprising at least one of a compound represented by formula (I); a hydrolysate of the compound represented by formula (I); and a condensate of the compound represented by formula (I) and the hydrolysate of the compound represented by formula (I): 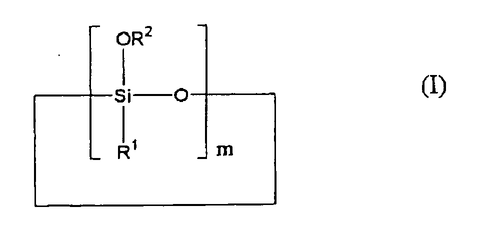 wherein m represents an integer of from 5 to 30;
   R¹ represents a hydrogen atom or a substituent; and
   R² represents a hydrogen atom or a group represented by formula (II), provided that at least one of R²S represents a group represented by formula (II): 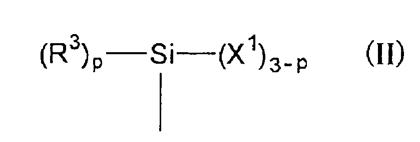 wherein R³ represents a hydrogen atom or a non-hydrolyzable group;
   X¹ represents a hydroxyl group or a hydrolyzable group; and
   p represents an integer of from 0 to 3.
(2) The composition as described in (1) above,
   wherein in formula (I), R¹ represents an aryl group, an alkyl group having 4 or more carbon atoms or a hydroxyl group.
(3) The composition as described in (2) above,
   wherein in formula (I), R¹ represents a phenyl group, a cyclopentyl group, a cyclohexyl group or a hydroxyl group.
(4) The composition as described in any of (1) to (3) above,
   wherein in formula (I), m represents an integer of 6, 8 or 12.
(5) The composition as described in any of (1) to (4) above, further comprising at least one of a compound represented by formula (III); a hydrolysate of the compound represented by formula (III); and a condensate of the compound represented by formula (III) and the hydrolysate of the compound represented by formula (III):

   R⁵ₙSiX²₄₋ₙ (III)

   wherein R⁵ represents a hydrogen atom or a non-hydrolyzable group;
   X² represents a hydrolyzable group; and
   n represents an integer of from 0 to 3.
(6) A process for producing a composition as described in any of (1) to (5) above, the process compsiring:
   reacting a compound represented by formula (IV) with a compound represented by formula (V): 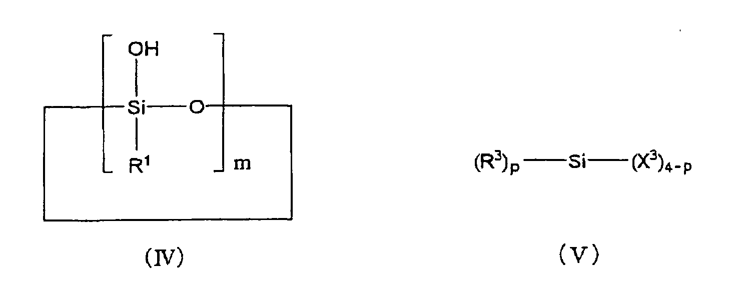
   wherein R¹, m, R³ and p have the same meanings as defined in formula (I) or (II); and
   X³ represents a hydrolyzable group; and
   then hydrolyzing the reaction product as needed.
(7) An insulating film obtained by utilizing a composition as described in any of (1) to (5) above.
(8) A process for producing an insulating film comprising:
   applying a composition as described in any of (1) to (5) above onto a substrate; and
   then calcinating the applied composition.
(9) A polymer obtained by utilizing a composition as described in any of (1) to (5) above.

### Detailed Description of the Invention

The compounds to be used in the present invention will next be described specifically.

The term "condensate" as used herein means a condensation product of silanol groups generated after the hydrolysis of a compound. All the silanol groups are not necessarily condensed and the term embraces a partial condensate and a mixture of the condensates different in the condensation degree.

The compound represented by the formula (I) will next be explained.

R¹ is a hydrogen atom or a substituent. Examples of the substituent include cyclic or linear alkyl groups, aryl groups, alkenyl groups, alkynyl groups, halogen atoms and hydroxyl group. These substituents may have a substituent further. As R¹, preferred are groups containing 4 or more carbon atoms from the standpoint of the formation of a film with a low dielectric constant. Of these, cycloalkyl groups and branched alkyl groups are preferred, cyclohexyl groups, cyclopentyl groups and t-butyl groups are more preferred, and cyclopentyl groups and cyclohexyl groups are most preferred. In addition, a phenyl group is preferred from the standpoint of the formation of a film with high heat resistance and high plasma resistance, and a hydroxyl group is preferred from the standpoint of the formation of a film with high strength. As to a group containing 4 or more carbon atoms as R¹, the upper limit of the number of carbon atoms is preferably 10.

R² represents a hydrogen atom or a group represented by the formula (II), but at least one of the R²s is a group represented by the formula (II). "m" stands for an integer of from 5 to 30, preferably from 6 to 30, and more preferably from 6 to 16 from the standpoint of a dielectric constant reducing effect. It is especially preferably 6, 8 and 12 from the standpoint of a synthesis suitability.

In the formula (II), R³ represents a hydrogen atom or a non-hydrolyzable group. Examples and preferable range of the non-hydrolyzable group are similar to those described in R¹.

Examples of the non-hydrolyzable group as R³ include cyclic or linear alkyl groups, aryl groups, alkenyl groups, alkynyl groups and a hydroxyl group. They may have a substituent further. As R³, preferred are cyclic or linear alkyl groups, aryl groups and hydroxyl group. Of these, cyclic alkyl groups (such as cyclopropyl and cyclohexyl) are preferred from the standpoint of the formation of a film with a low dielectric constant; a methyl group is preferred from the standpoint of the formation of a film with high heat resistance; aryl groups (such as phenyl group) are preferred from the standpoint of the formation of a film with high plasma resistance; and a hydroxyl group is preferred from the standpoint of the formation of a film with high strength.

Examples of the X¹ include hydroxyl group, alkoxyl groups, aryloxy groups, acyloxy groups and arylcarbonyloxy groups and halogen atoms. Of these, hydroxyl, alkoxyl and acyloxy groups are preferred, with the hydroxyl group being most preferred.

"p" stands for an integer of from 0 to 3 and it is preferably from 0 to 2 from the standpoint of the film strength.

A silicon-containing group represented by the formula (II) has at least one hydroxyl group as X¹.

The cyclic structure of the compound in the formula (I) may be composed of a single unit or a plurality of units different from each other.

No particular limitation is imposed on the three-dimensional positional relationship of the substituent in the formula (I). All the R¹S may exist in the same direction relative to the ring formed by -Si-O or their directions may vary regularly. They may have no regularity, but it is preferred that their directions have certain regularity in order to form a uniform structure in the film.

The composition of the invention may contain a plurality of compounds which are represented by the formula (I) but different from each other, or condensates thereof.

The followings are specific examples of the formula (I), but the invention is not limited thereto.

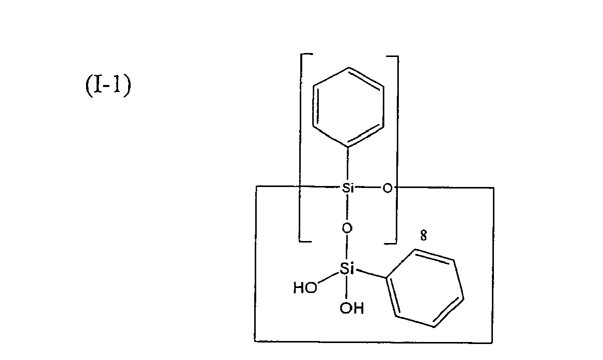

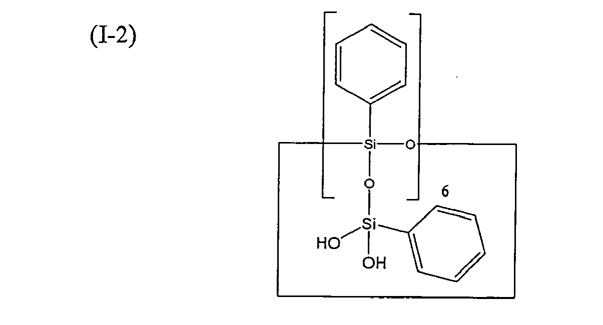

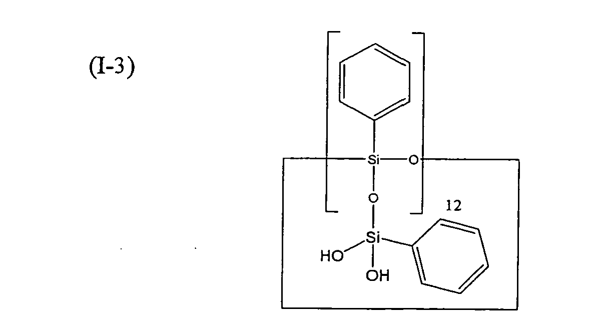

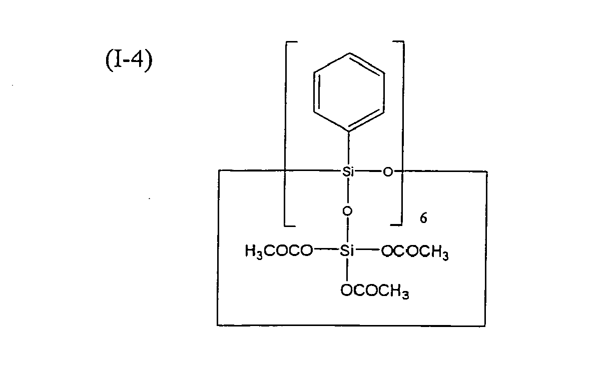

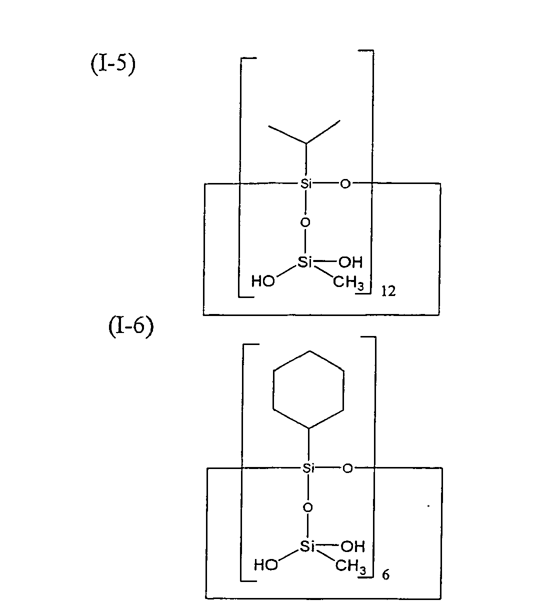

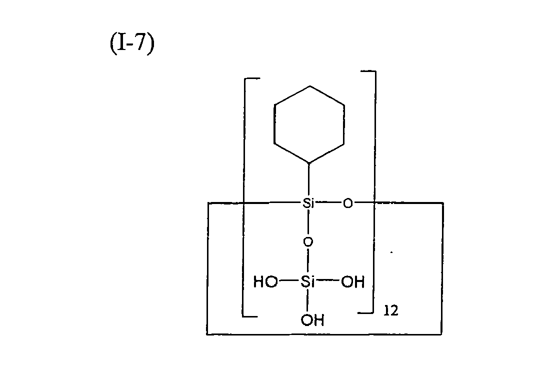

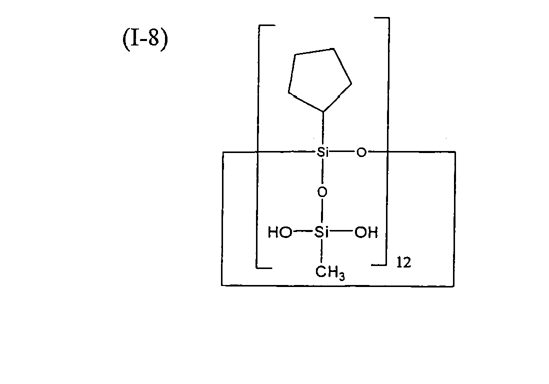

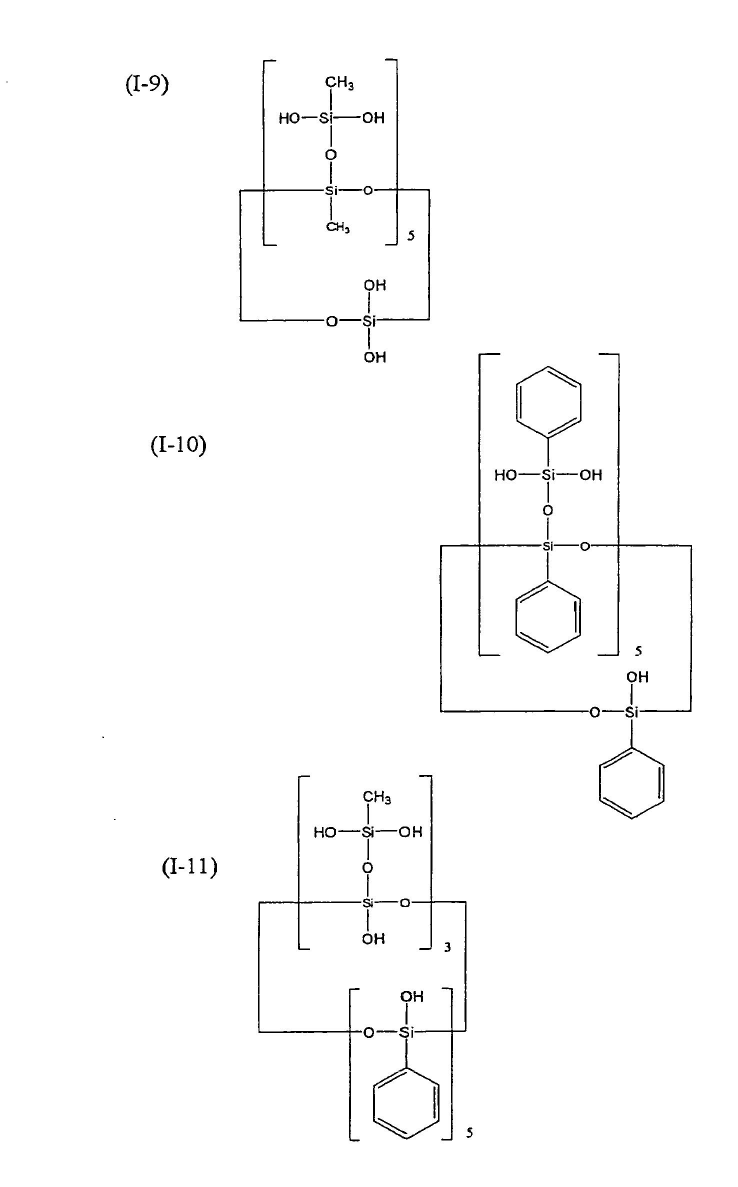

The compounds represented by the formula (I) can be synthesized by reacting a compound represented by formula (IV) with a compound represented by the formula (V) in accordance with the process as described in Inorganic Chemistry, 41, 6898-6904(2002), J. Gen. Chem. USSR, 61;6.2, 1257-1261(1991), WO2003104305, Journal of Organometallic Chemistry, 514(1-2), 29-35(1996) or the like.
wherein, R¹, m, R³ and p have the same meanings as described above in the formula (I) or (II), and X³ represents a hydrolyzable group.

Examples of the hydrolyzable group as X³ include alkoxy groups, aryloxy groups, halogen atoms and acyloxy groups. Of these, alkoxy groups, acyloxy groups and chlorine atom are preferred.

The reaction between the compound represented by the formula (IV) and the compound represented by the formula (V) is performed usually at from 0 to 180°C for 10 minutes to 20 hours by adding the compound of the formula (V) to a solution containing the compound of the formula (IV) while stirring. As the solvent, an organic solvent such as tetrahydrofuran (THF) is preferred.

When reacting the compound of the formula (IV) with the compound of the formula (V), base such as triethylamine is preferably added.

The compound thus synthesized can be converted into the compound of the formula (I) by reacting it with water, alcohol or the like as needed.

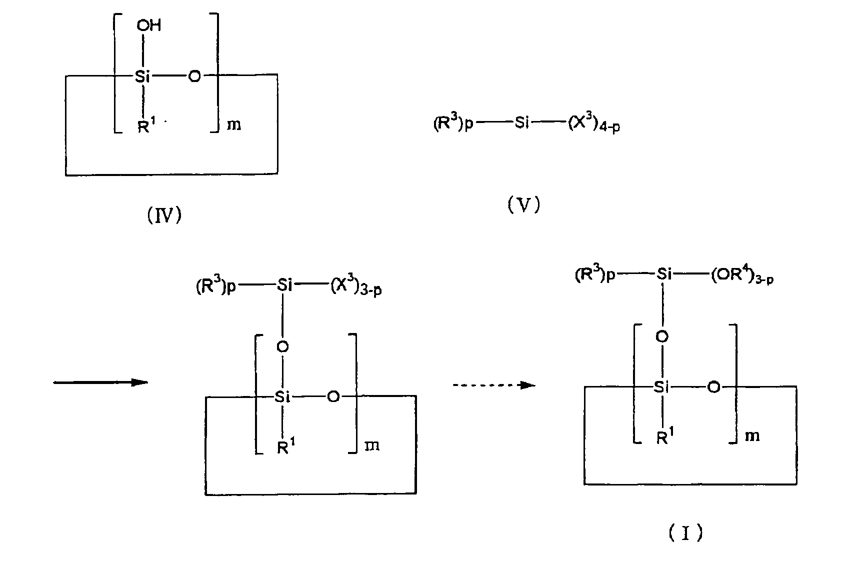

R⁴ represents a hydrogen atom, alkyl group, aryl group, acyl group or arylcarbonyl group.

The composition of the invention may contain, in addition to the compound represented by the formula (I), a compound represented by the formula (III), a hydrolysate of the compound (III), or a condensate of the compound (III) or hydrolysate.

R⁵ₙSiX²₄₋ₙ (III)

R⁵ represents a hydrogen atom or a non-hydrolyzable group, of which methyl, phenyl or cycloalkyl group is preferred.

X² represents a hydrolyzable group. Examples of the X² include alkoxy groups, aryloxy groups, halogen atoms and acyloxy groups. From the standpoint of stability of a coating solution, X² is preferably an alkoxy group. The alkoxy group is preferably a lower alkoxy group having from 1 to 5 carbon atoms. It may be linear or branched. Moreover, the hydrogen atom of it may be substituted with a fluorine atom. Methoxy and ethoxy groups are most preferred as X².

"n" stands for an integer of from 0 to 3, and it is preferably 1 or 0 from the standpoint of film strength.

Specific examples of the compound represented by the formula (III) include methyltrimethoxysilane, methyltriethoxysilane, phenyltrimethoxysilane and tetraethoxysilane.

In preparing the composition of the invention, a basic catalyst, acidic catalyst or metal chelate compound may be used when the silane compound is hydrolyzed and/or condensed.

Examples of the basic catalyst include sodium hydroxide, potassium hydroxide, lithium hydroxide, pyridine, pyrrole, piperazine, pyrrolidine, piperidine, picoline, monoethanolamine, diethanolamine, dimethylmonoethanolamine, monomethyldiethanolamine, triethanolamine, diazabicyclooctane, diazabicyclononane, diazabicycloundecene, tetramethylammonium hydroxide, tetraethylammonium hydroxide, tetrapropylammonium hydroxide, tetrabutylammonium hydroxide, ammonia, methylamine, ethylamine, propylamine, butylamine, pentylamine, hexylamine, octylamine, nonylamine, decylamine, N,N-dimethylamine, N,N-diethylamine, N,N-dipropylamine, N,N-dibutylamine, trimethylamine, triethylamine, tripropylamine, tributylamine, cyclohexylamine, trimethylimidine, 1-amino-3-methylbutane, dimethylglycine, and 3-amino-3-methylamine. Of these, preferred are the amines and amine salts, with the organic amines and organic amine salts being especially preferred. Most preferred are the alkylamines and tetraalkylammonium hydroxides. These alkali catalysts may be used either singly or in combination of two or more.

Examples of the metal chelate compound include titanium chelate compounds such as triethoxy · mono (acetylacetonato) titanium, tri-n-propoxy·mono (acetylacetonato) titanium, tri-i-propoxy · mono (acetylacetonato) titanium, tri-n-butoxy · mono (acetylacetonato) titanium, tri-sec-butoxy · mono (acetylacetonato) titanium, tri-t-butoxy · mono (acetylacetonato) titanium, diethoxy bis(acetylacetonato)titanium, di-n-propoxy·bis(acetylacetonato)titanium, di-i-propoxybis(acetylacetonato)titanium, di-n-butoxy·bis(acetylacetonato) titanium, di-sec-butoxy·bis(acetylacetonato) titanium, di-t-butoxy · bis (acetylacetonato) titanium, monoethoxy · tris (acetylacetonato) titanium, mono-n-propoxy · tris (acetylacetonato) titanium, mono-i-propoxy · tris (acetylacetonato) titanium, mono-n-butoxy · tris (acetylacetonato) titanium, mono-sec-butoxy · tris (acetylacetonato) titanium, mono-t-butoxy · tris (acetylacetonato) titanium, tetrakis(acetylacetonato)titanium, triethoxy · mono (ethylacetoacetato) titanium, tri-n-propoxy · mono (ethylacetoacetato) titanium, tri-i-propoxy · mono (ethylacetoacetato) titanium, tri-n-butoxy · mono (ethylacetoacetato) titanium, tri-sec-butoxy · mono (ethylacetoacetato) titanium, tri-t-butoxy·mono(ethylacetoacetato)titanium, diethoxy·bis(ethylacetoacetato)titanium, di-n-propoxy·bis(ethylacetoacetato)titanium, di-i-propoxy·bis(ethylacetoacetato)titanium, di-n-butoxy-bis(ethylacetoacetato)titanium, di-sec-butoxy·bis(ethylacetoacetato)titanium, di-t-butoxy·bis(ethylacetoacetato)titanium, monoethoxy·tris(ethylacetoacetato)titanium, mono-n-propoxy·tris(ethylacetoacetato)titanium, mono-i-propoxy·tris(ethylacetoacetato)titanium, mono-n-butoxy·tris(ethylacetoacetato)titanium, mono-sec-butoxy·tris(ethylacetoacetato)titanium, mono-t-butoxy·tris(ethylacetoacetato)titanium, tetrakis(ethylacetoacetato)titanium, mono (acetylacetonato)tris(ethylacetoacetato)titanium, bis(acetylacetonato)bis(ethylacetoacetato)titanium, and tris(acetylacetonato)mono(ethylacetoacetato)titanium; zirconium chelate compounds such as triethoxy·mono(acetylacetonato)zirconium, tri-n-propoxy·mono(acetylacetonato)zirconium, tri-i-propoxy·mono(acetylacetonato)zirconium, tri-n-butoxy·mono(acetylacetonato)zirconium, tri-sec-butoxy·mono(acetylacetonato)zirconium, tri-t-butoxy·mono(acetylacetonato)zirconium, diethoxy·bis(acetylacetonato)zirconium, di-n-propoxy·bis(acetylacetonato)zirconium, di-i-propoxy·bis(acetylacetonato)zirconium, di-n-butoxy·bis(acetylacetonato)zirconium, di-sec-butoxy·bis(acetylacetonato)zirconium, di-t-butoxy·bis(acetylacetonato)zirconium, monoethoxy·tris(acetylacetonato)zirconium, mono-n-propoxy·tris(acetylacetonato)zirconium, mono-i-propoxy·tris(acetylacetonato)zirconium, mono-n-butoxy·tris(acetylacetonato)zirconium, mono-sec-butoxy·tris(acetylacetonato)zirconium, mono-t-butoxy·tris(acetylacetonato)zirconium, tetrakis(acetylacetonato)zirconium, triethoxy·mono(ethylacetoacetato)zirconium, tri-n-propoxy·mono(ethylacetoacetato)zirconium, tri-i-propoxy·mono(ethylacetoacetato)zirconium, tri-n-butoxy·mono(ethylacetoacetato)zirconium, tri-sec-butoxy·mono(ethylacetoacetato)zirconium, tri-t-butoxy·mono(ethylacetoacetato)zirconium, diethoxy·bis(ethylacetoacetato)zirconium, di-n-propoxy·bis(ethylacetoacetato)zirconium, di-i-propoxy·bis(ethylacetoacetato)zirconium, di-n-butoxy·bis(ethylacetoacetato)zirconium, di-sec-butoxy·bis(ethylacetoacetato)zirconium, di-t-butoxy·bis(ethylacetoacetato)zirconium, monoethoxy·tris(ethylacetoacetato)zirconium, mono-n-propoxy·tris(ethylacetoacetato)zirconium, mono-i-propoxy·tris(ethylacetoacetato)zirconium, mono-n-butoxy·tris(ethylacetoacetato)zirconium, mono-sec-butoxy·tris(ethylacetoacetato)zirconium, mono-t-butoxy·tris(ethylacetoacetato)zirconium, tetrakis(ethylacetoacetato)zirconium, mono(acetylacetonato)tris(ethylacetoacetato)zirconium, bis(acetylacetonato)bis(ethylacetoacetato)zirconium, and tris(acetylacetonato)mono(ethylacetoacetato)zirconium; and aluminum chelate compounds such as tris(acetylacetonato)aluminum and tris(ethylacetoacetato)aluminum. Of these, preferred are the titanium and aluminum chelate compounds, with the titanium chelate compounds being especially preferred. These metal chelate compounds may be used either singly or in combination of two or more.

Examples of the acid catalyst include inorganic acids such as hydrochloric acid, nitric acid, sulfuric acid, hydrofluoric acid, phosphoric acid, boric acid and oxalic acid; and organic acids such as acetic acid, propionic acid, butanoic acid, pentanoic acid, hexanoic acid, heptanoic acid, octanoic acid, nonanoic acid, decanoic acid, oxalic acid, maleic acid, methylmalonic acid, adipic acid, sebacic acid, gallic acid, butyric acid, mellitic acid, arachidonic acid, shikimic acid, 2-ethylhexanoic acid, oleic acid, stearic acid, linoleic acid, linolenic acid, salicylic acid, benzoic acid, p-aminobenzoic acid, p-toluenesulfonic acid, benzenesulfonic acid, monochloroacetic acid, dichloroacetic acid, trichloroacetic acid, trifluoroacetic acid, formic acid, malonic acid, sulfonic acid, phthalic acid, fumaric acid, citric acid, tartaric acid, succinic acid, itaconic acid, mesaconic acid, citraconic acid, malic acid, a hydrolysate of glutaric acid, a hydrolysate of maleic anhydride, and a hydrolysate of phthalic anhydride. Of these, the organic carboxylic acids are more preferred. These acid catalysts may be used either singly or in combination of two or more.

The amount of the catalyst is usually from 0.00001 to 10 moles, preferably from 0.00005 to 5 moles, per mole of the total amount of the silane compounds such as the compounds represented by the formula (I) and (III). In the invention, the temperature at the time of the condensation of the compound represented by the formula (I) is usually from 0 to 200°C, preferably from 10 to 150°C.

The insulating film forming composition of the invention is applied to a support after dissolving the composition in a solvent. Preferred examples of usable solvent include ethylene dichloride, cyclohexanone, cyclopentanone, 2-heptanone, methyl isobutyl ketone, γ-butyrolactone, methyl ethyl ketone, methanol, ethanol, dimethylimidazolidinone, ethylene glycol monomethyl ether, ethylene glycol monoethyl ether, ethylene glycol dimethyl ether, 2-methoxyethyl acetate, ethylene glycol monoethyl ether acetate, propylene glycol monomethyl ether (PGME), propylene glycol monomethyl ether acetate (PGMEA), tetraethylene glycol dimethyl ether, triethylene glycol monobutyl ether, triethylene glycol monomethyl ether, isopropanol, ethylene carbonate, ethyl acetate, butyl acetate, methyl lactate, ethyl lactate, methyl methoxypropionate, ethyl ethoxypropionate, methyl pyruvate, ethyl pyruvate, propyl pyruvate, N,N-dimethylformamide, dimethylacetamide, dimethyl sulfoxide, N-methylpyrrolidone, tetrahydrofuran, diisopropylbenzene, toluene, xylene, and mesitylene. These solvents may be used either singly or as a mixture.

Of these, preferred solvents include propylene glycol monomethyl ether acetate, propylene glycol monomethyl ether, 2-heptanone, cyclohexanone, γ-butyrolactone, ethylene glycol monomethyl ether, ethylene glycol monoethyl ether, ethylene glycol monoethyl ether acetate, propylene glycol monomethyl ether, propylene glycol monoethyl ether, ethylene carbonate, butyl acetate, methyl lactate, ethyl lactate, methyl methoxypropionate, ethyl ethoxypropionate, N-methylpyrrolidone, N,N-dimethylformamide, tetrahydrofuran, methyl isobutyl ketone, xylene, mesitylene, and diisopropylbenzene.

The total solid concentration of the composition of the invention thus obtained is preferably from 2 to 30 mass%. (In this specification, mass% and parts by mass are equal to weight% and parts by weight, respectively.) It is regulated as needed depending on the using purpose. When the total solid concentration of the composition is from 2 to 30 mass%, the thickness of the film falls within an appropriate range and the coating solution has improved storage stability.

When the insulating film forming material of the invention thus obtained is applied to a base material such as silicon wafer, SiO₂ wafer, or SiN wafer, a coating technique such as spin coating, dipping, roll coating, or spraying is employed.

A film having a dry film thickness of from about 0.05 to 1.5 µm can be formed by applying the material once, while that of from about 0.1 to 3 µm can be formed by applying the material twice. Thereafter, the film is dried at ordinary temperature or dried by heating with a hot plate, oven or furnace, whereby a vitreous insulating film, macromolecular insulating film, or a mixture thereof can be formed.

The heating can be conducted in a nitrogen atmosphere, argon atmosphere, or under vacuum. The calcination is preferably conducted under the conditions of the maximum calcination temperature of 300°C or greater but not greater than 430°C.

More specifically, the insulating film forming material of the invention is applied to a substrate (usually, a substrate having a metal wiring thereon), for example, by spin coating and subjected to preliminary heat treatment, whereby the solvent is distilled off and the siloxane contained in the film forming composition is crosslinked to some extent. The final heat treatment (annealing) is then conducted at a temperature of 300°C or greater but not greater than 430°C. Thus, an insulating film having a low dielectric constant can be formed.

By the above-described method, an insulating film having a low dielectric constant, more specifically, a specific dielectric constant as low as 2.6 or less, preferably 2.4 or less can be obtained. The dielectric constant may be reduced further by adding a thermally decomposable compound or the like to the composition of the invention, thereby making the film porous.

### [Examples]

The invention will hereinafter be explained in more detail by Example. In the following Example, all designations of "part" or "parts" and "%" as will be used in the following Example mean part or parts by mass and mass% unless otherwise specifically indicated.

### [Synthesis Example 1]

1 g of Compound (I-A-a) synthesized in accordance with the process as described in Journal of Organometallic Chemistry, 514(1-2), 29-35(1996) was dissolved in 10 ml of tetrahydrofuran. Under ice cooling, 1.6 g of trichlorophenylsilane and 1.1 ml of triethylamine were added dropwise. After stirring at room temperature for 1 hour, the reaction mixture was filtered to remove the salt therefrom. The residue was concentrated under reduced pressure to yield Compound (I-A-b). The resulting compound was dissolved in 5 ml of ethyl acetate. While keeping the temperature of the resulting solution at 0°C, 20 ml of water was added thereto and the mixture was stirred for 1 hour. The organic layer obtained by the separation of the reaction mixture was washed with water, followed by the addition of 5 ml of cyclohexanone to yield Composition (I-A-c) containing Compound (I-A) and the condensate of the Compound (I-A) of the invention.

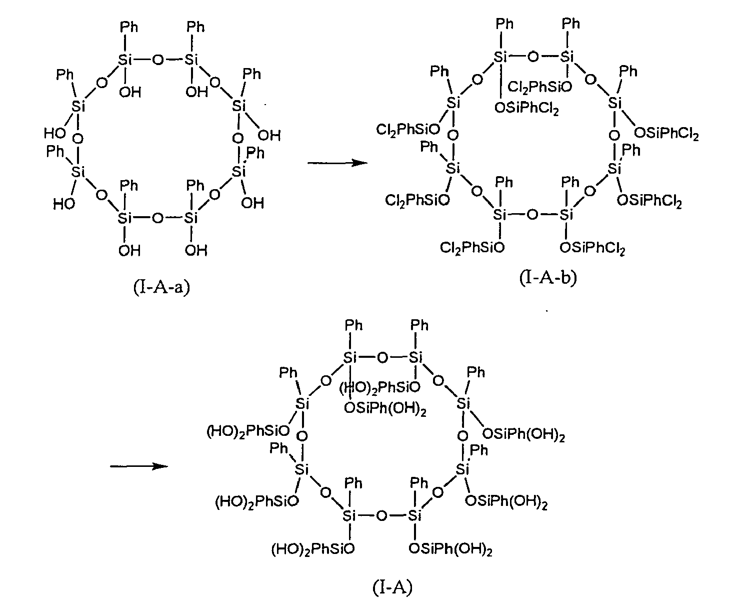

### [Synthesis Example 2]

Compound (I-B-b) was obtained by conducting the same reaction as in Synthesis Example 1 except for using 1 g of Compound (I-B-a) synthesized in accordance with the process as described in Inorganic Chemistry, 41, 6898-6904(2002) instead of Compound (I-A-a). Further, Composition (I-B-c) containing Compound (I-B) and the condensate of the Compound (I-B) of the invention were obtained by conducting the same treatments as in Synthesis Example 1 except for using Compound (I-B-b) instead of Compound (I-A-b).

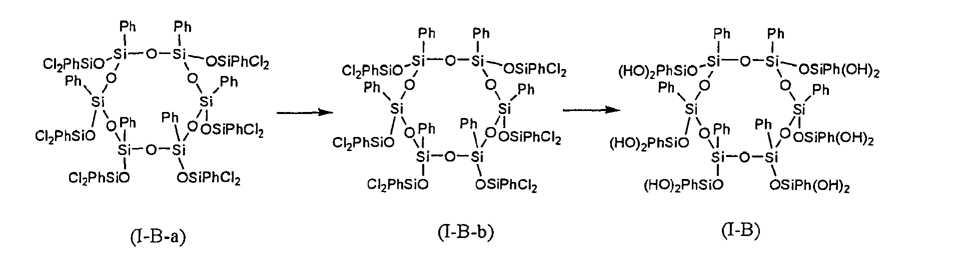

### [Synthesis Example 3]

Compound (I-C-b) was obtained by conducting the same reaction as in Synthesis Example 1 except for using 1 g of Compound (I-C-a) synthesized by the same process as in Synthesis Example 2 instead of Compound (I-A-a). Further, Composition (I-C-c) containing Compound (I-C) and the condensate of the Compound (I-C) of the invention were obtained by conducting the same treatments as in Synthesis Example 1 except for using Compound (I-C-b) instead of Compound (I-A-b).

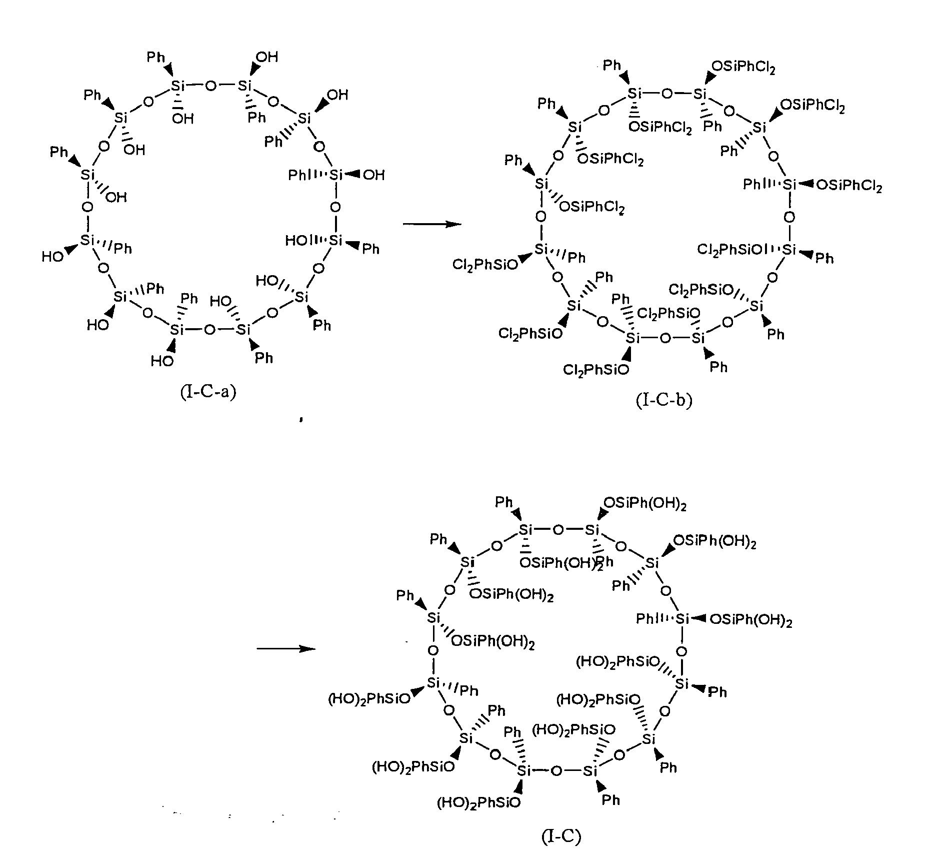

### [Synthesis Example 4]

Compound (I-D-b) was obtained by conducting the same reaction as in Synthesis Example 1 except for using 1 g of Compound (I-B-a) and cyclopentyltrichlorosilane instead of Compound (I-A-a). Further, Composition (I-D-c) containing Compound (I-D) and the condensate of the Compound (I-D) of the invention were obtained by conducting the same treatments as in Synthesis Example 1 except for using Compound (I-D-b) instead of Compound (I-A-b).

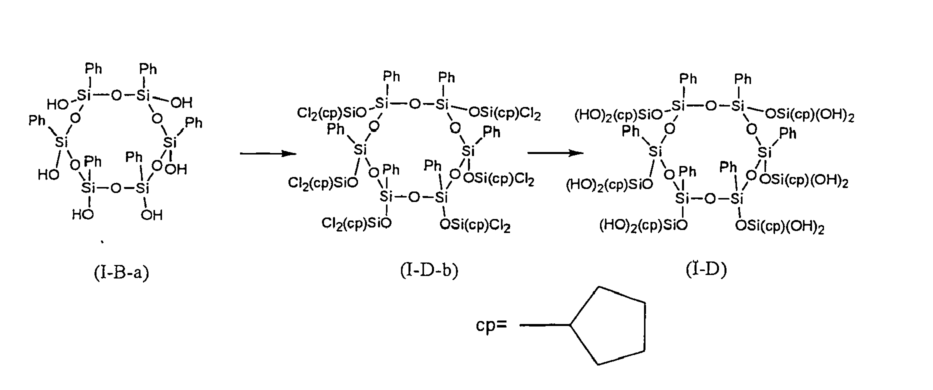

### [Synthesis Example 5]

Compound (I-E-a) was obtained by reducing Compound (I-B-a) in accordance with the method as described in Bull. Chem. Soc. Jpn., 27, 441-443(1954). Compound (I-E-b) was obtained by conducting the same reaction as in Synthesis Example 1 except for using 1 g of Compound (I-E-a) instead of Compound (I-A-a). Further, Composition (I-E-c) containing Compound (I-E) and the condensate of the Compound (I-E) of the invention were obtained by conducting the same treatments as in Synthesis Example 1 except for using Compound (I-E-b) instead of Compound (I-A-b) .

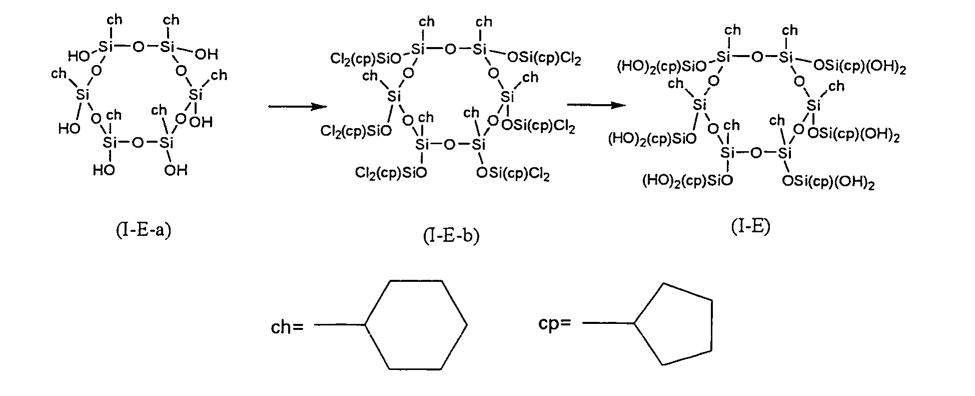

### [Synthesis Example 6]

Comparative Compound (1-b) was synthesized by conducting the similar reaction using Comparative Compound (1-a) as in the above. Further, Comparative Composition (1-c) containing Comparative Compound 1 and the condensate of the Comparative Compound 1 were obtained by conducting the similar treatments as in the above.

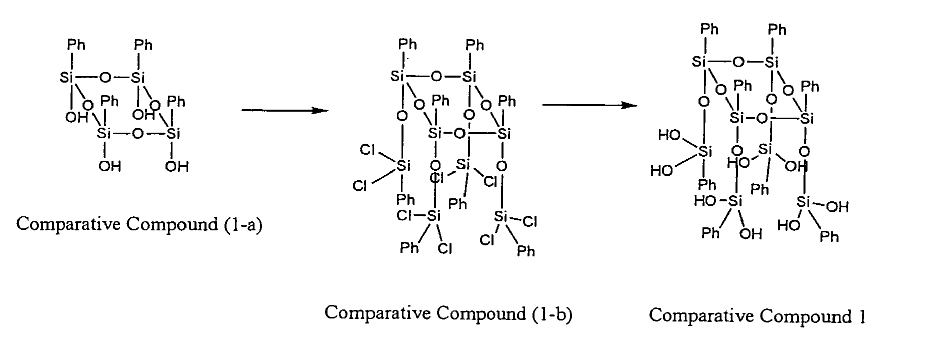

### (Example)

Each of the compositions obtained in Synthesis Examples was filtered through a filter with 0.2 µm pore size made of Teflon (trade mark) and applied onto a 4-inch silicon wafer by spin coating. The resulting substrate was dried on a hot plate at 130°C for 1 minute and then 230°C for 1 minute, followed by heating in a clean oven of nitrogen atmosphere for 30 minutes at 40°C to form a film. The dielectric constant of the film was measured (measurement temperature 25°C) using a mercury probe manufactured by Four Dimensions Inc, thereby obtaining the specific dielectric constant.

Evaluation results of the films thus obtained are shown in Table 1.

**Table 1**

| Composition | Specific dielectric constant |
|---|---|
| I-A-c | 2.49 |
| I-B-c | 2.56 |
| I-C-c | 2.55 |
| I-D-c | 2.43 |
| I-E-c | 2.41 |
| Comparative Composition 1-c | 2.66 |

The results have revealed that a film with a low dielectric constant can be formed using the compositions of the invention.

The present invention makes it possible to form an insulating film suited for use as an interlayer insulating film of a semiconductor element or the like and having excellent dielectric constant characteristics.

The entire disclosure of each and every foreign patent application from which the benefit of foreign priority has been claimed in the present application is incorporated herein by reference, as if fully set forth.

## Claims

1. A composition comprising at least one of a compound represented by formula (I); a hydrolysate of the compound represented by formula (I); and a condensate of the compound represented by formula (I) and the hydrolysate of the compound represented by formula (I): 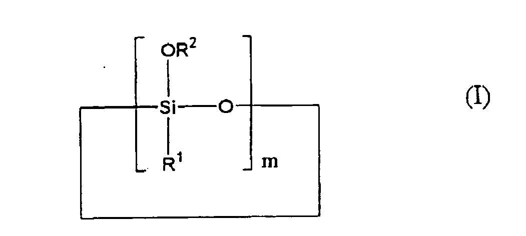 wherein m represents an integer of from 5 to 30;
R¹ represents a hydrogen atom or a substituent; and
R² represents a hydrogen atom or a group represented by formula (II), provided that at least one of R² S represents a group represented by formula (II): 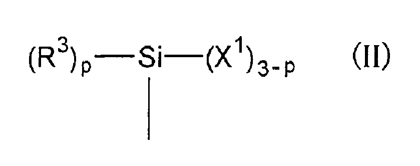 wherein R³ represents a hydrogen atom or a non-hydrolyzable group;
X¹ represents a hydroxyl group or a hydrolyzable group; and
p represents an integer of from 0 to 3.

2. The composition according to claim 1,
wherein in formula (I), R¹ represents an aryl group, an alkyl group having 4 or more carbon atoms or a hydroxyl group.

3. The composition according to claim 2,
wherein in formula (I), R¹ represents a phenyl group, a cyclopentyl group, a cyclohexyl group or a hydroxyl group.

4. The composition according to claim 1,
wherein in formula (I), m represents an integer of 6, 8 or 12.

5. The composition according to claim 1, further comprising at least one of a compound represented by formula (III); a hydrolysate of the compound represented by formula (III); and a condensate of the compound represented by formula (III) and the hydrolysate of the compound represented by formula (III):
R⁵ₙSiX²₄₋ₙ (III)
wherein R⁵ represents a hydrogen atom or a non-hydrolyzable group;
X² represents a hydrolyzable group; and
n represents an integer of from 0 to 3.

6. A process for producing a composition according to claim 1, the process compsiring:
reacting a compound represented by formula (IV) with a compound represented by formula (V): 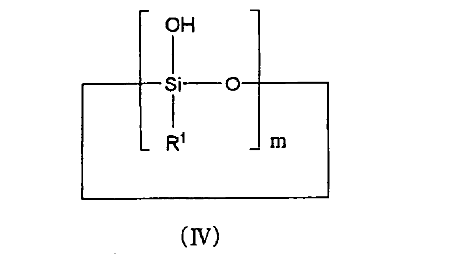 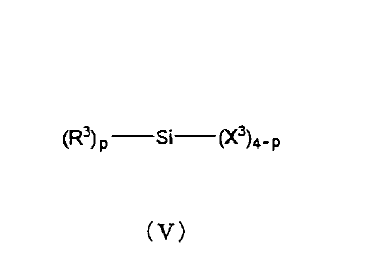
wherein R¹, m, R³ and p have the same meanings as defined in formula (I) or (II); and
x³ represents a hydrolyzable group; and
then hydrolyzing the reaction product as needed.

7. An insulating film obtained by utilizing a composition according to claim 1.

8. A process for producing an insulating film comprising:
applying a composition according to claim 1 onto a substrate; and
then calcinating the applied composition.

9. A polymer obtained by utilizing a composition according to claim 1.
